# FASCICULE DE BREVET EUROPEEN

(11) **EP 1 111 621 B1**
(45) Date de publication et mention de la délivrance du brevet: **21.12.2011**
(21) Numéro de dépôt: 00125553.8
(22) Date de dépôt: 22.11.2000
(51) Int. Cl.: G11C 16/10

(54) **Mémoire flash programmable page par page**
Seitenprogrammierbar Flash-Speicher
Page programmable flash memory

(30) Priorité: 22.12.1999 FR 9916445
(43) Date de publication de la demande: 27.06.2001
(73) Titulaire: STMicroelectronics SA, F-92120 Montrouge (FR)
(72) Inventeur: Zink, Sébastien, 13086 Aix en Provence (FR); Cavaleri, Paola, Quartier Tartanne, 13790 Rousset (FR); Leconte, Bruno, 13790 Rousset (FR)
(74) Mandataire: Viering, Jentschura & Partner

(56) Documents cités:
- EP-A- 0 561 271
- WO-A-97/48101
- DE-A- 19 506 957
- US-A- 4 763 305
- US-A- 5 363 330
- US-A- 5 488 711
- US-A- 5 621 738
- US-A- 5 986 965

## Description

La présente invention concerne les mémoires effaçables et programmables électriquement, ou mémoires EEPROM, et plus particulièrement les mémoires EEPROM du type FLASH.

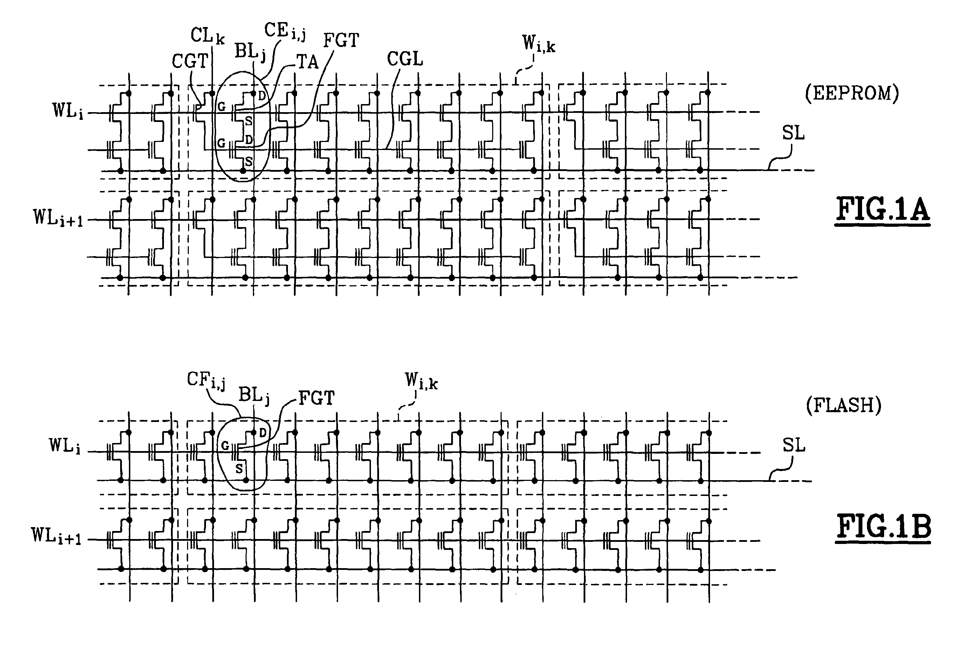

A l'heure actuelle, le marché des mémoires en circuits intégrés effaçables et programmables électriquement est divisé en trois grandes catégories de mémoires : les mémoires EEPROM programmables mot par mot, les mémoires EEPROM programmables page par page, une page comprenant une pluralité de mots, et les mémoires FLASH (ou FLASH-EEPROM) programmables mot par mot. La catégorie des mémoires FLASH programmables page par page n'existe pas en raison de particularités technologiques de ces mémoires qui seront brièvement rappelées en se référant aux figures 1A et 1B.

La figure 1A représente schématiquement le coeur d'une mémoire EEPROM et la figure 1B représente le coeur d'une mémoire FLASH. Chaque mémoire comprend une pluralité de cellules mémoire, respectivement CE_{i,j}, CF_{i,j}, agencées de façon matricielle et connectées à des lignes de mots WLᵢ et des lignes de bits BLⱼ.

Sur la figure 1A, on voit que les cellules CE_{i,j} de la mémoire EEPROM comportent un transistor à grille flottante FGT et un transistor d'accès TA. Le transistor d'accès TA a sa grille G connectée à une ligne de mots WLᵢ, son drain D connecté à une ligne de bits BLⱼ, sa source S étant connectée au drain D du transistor FGT. Le transistor FGT a sa grille G reliée à une ligne de sélection de colonne CLₖ par l'intermédiaire d'une ligne de contrôle de grille CGL et d'un transistor de contrôle de grille CGT, et sa source S connectée à une ligne de source SL, la grille du transistor CGT étant connectée à la ligne de mots WLᵢ. Ainsi, les cellules mémoire CE_{i,j} d'une même ligne de mots WLᵢ sont arrangées en colonnes de rang k, et forment des mots W_{i,k}, généralement des octets, pouvant être sélectionnés en lecture au moyen de la ligne de sélection de colonne CLₖ et de la ligne de mots WLᵢ auxquelles ils sont rattachés.

Dans une telle mémoire EEPROM, une opération d'effacement ou de programmation d'une cellule consiste dans l'injection ou l'extraction de charges électriques par effet tunnel (effet Fowler Nordheim) dans la grille flottante du transistor FGT de la cellule. Un transistor FGT effacé présente une tension de seuil positive VT1 et un transistor FGT programmé présente une tension de seuil négative VT2. Lorsqu'une tension de lecture Vread comprise entre VT1 et VT2 est appliquée sur sa grille, un transistor effacé reste bloqué, ce qui correspond par convention à un "0" logique, et un transistor programmé est passant, ce qui correspond par convention à un "1" logique. L'opération d'effacement est réalisée en appliquant une tension d'effacement VPP de l'ordre de 12 à 20 V sur la grille G du transistor FGT pendant que la ligne de source SL est portée à la masse. L'opération de programmation est réalisée en appliquant une tension de programmation VPP sur le drain D du transistor FGT, par l'intermédiaire du transistor d'accès TA, pendant que la grille est portée à la masse.

Les transferts de charges par effet tunnel s'effectuant avec un courant de grille quasiment nul, un grand nombre de cellules mémoire EEPROM peuvent être effacées ou programmées simultanément. Ainsi, comme indiqué plus haut, on trouve sur le marché des mémoires intégrées, des mémoires EEPROM à programmation par page qui sont appréciées en ce qu'elles permettent, après une opération collective d'effacement de toutes les cellules d'une page (mise à "0"), de programmer simultanément toutes les cellules de la page devant contenir la valeur "1", par exemple 256 cellules en même temps.

Sur la figure 1B, on voit que les cellules CF_{i,j} de la mémoire FLASH sont d'une structure très simple et ne comportent qu'un transistor à grille flottante FGT. Le transistor FGT a sa grille G connectée à une ligne de mots WLᵢ, son drain D connecté à une ligne de bits BLⱼ et sa source S connectée à une ligne de source SL, parfois par l'intermédiaire d'un transistor de source comme cela est décrit dans la demande EP704851 (non représenté). L'arrangement des cellules d'un même mot peut être progressif ou entrelacé, de sorte qu'un mot W_{i,k} rattaché à une ligne de rang i et à une colonne de rang k peut comprendre huit cellules agencées côte à côte comme représenté sur la figure 1B ou comprendre, dans le cas d'un entrelacement, des cellules non adjacentes. Dans ce cas, les cellules physiquement adjacentes sont généralement les cellules de même rang des mots d'une même ligne de mots.

Dans une telle mémoire FLASH, une opération d'effacement d'une cellule consiste dans l'extraction par effet tunnel de charges électriques piégées dans la grille flottante, tandis qu'une opération de programmation consiste dans l'injection de charges dans la grille flottante par effet dit "d'injection d'électrons chauds" (Hot electron injection). Un transistor FGT effacé présente une tension de seuil positive VT1 de faible valeur, et un transistor programmé présente une tension de seuil VT2 supérieure à VT1. Lorsqu'une tension de lecture Vread comprise entre VT1 et VT2 est appliquée sur sa grille, un transistor effacé est passant, ce qui correspond par convention à un "1" logique, et un transistor programmé reste bloqué, ce qui correspond par convention à un "0" logique.

En raison de leur simplicité, les mémoires FLASH présentent l'avantage d'une grande compacité en termes de surface de silicium occupée et présentent ainsi, à surface de silicium constante, une capacité de stockage nettement supérieure à celle des mémoires EEPROM, pour un prix de revient inférieur.

En revanche, les mémoires FLASH offrent des possibilités de programmation plus réduites que les mémoires EEPROM, notamment en ce qui concerne la possibilité d'enregistrer simultanément plusieurs mots. En effet, l'opération de programmation d'une cellule FLASH, par injection d'électrons chauds, s'effectue avec un courant non négligeable en appliquant au transistor FGT de la cellule une tension de drain de l'ordre de 6 V et une tension de grille de l'ordre de 12 V, le transistor FGT étant dans l'état passant et fortement polarisé pendant l'opération.

Ainsi, s'il est courant de prévoir des mémoires FLASH dans lesquelles toutes les cellules d'un même secteur sont effacées simultanément (un secteur comprenant plusieurs lignes de mots), la programmation simultanée d'un grand nombre de cellules FLASH s'avère par contre impossible en raison du courant important collecté dans les lignes de source SL, qui est capable de détruire les pistes métalliques reliant les transistors de la mémoire et/ou les connexions entre pistes de niveaux différents. En pratique, le nombre de cellules pouvant être simultanément programmées est généralement limité à huit, de sorte qu'une mémoire FLASH ne peut permettre l'enregistrement simultané de plusieurs mots et fonctionne toujours selon le mode de programmation "mot par mot".

Bien que cet inconvénient soit compensé par un temps de programmation très court, de l'ordre de quelques microsecondes contre quelques millisecondes pour une mémoire EEPROM, l'enregistrement d'une suite de mots dans une mémoire FLASH nécessite l'envoi d'une instruction de programmation à chaque mot enregistré. Inversement, une mémoire EEPROM programmable page par page ne nécessite qu'une seule instruction de programmation suivie de la suite de mots à enregistrer. Les mots sont stockés dans une bascule à verrouillage à sortie parallèle et sont enregistrés simultanément dans la mémoire EEPROM, en une seule étape.

En définitive, il existe de nombreux circuits électroniques, par exemple des cartes à microprocesseur, des cartes de micro-ordinateurs, des cartes son, des cartes graphiques,... qui sont équipés de mémoires EEPROM à programmation page par page et ne peuvent pas fonctionner avec des mémoires FLASH car leur protocole de transfert de données n'est pas compatible avec de telles mémoires.

Ainsi, un objectif général de la présente invention est de prévoir une mémoire FLASH ayant une interface mémoire/utilisateur compatible avec celle des mémoires EEPROM, et qui soit susceptible de remplacer les mémoires EEPROM dans les applications existantes pour bénéficier du prix de revient réduit des mémoires FLASH et de leur faible encombrement.

Un autre objectif général de la présente invention est de prévoir une mémoire FLASH capable de rivaliser avec les mémoires EEPROM en termes de souplesse d'emploi, sans augmenter de façon rédhibitoire le prix de revient d'une telle mémoire et sans perdre les avantages d'une telle mémoire en termes de capacité de stockage par unité de surface de silicium.

On connaît déjà par le brevet FR -A- 2 756 410 ou son équivalent EP -A- 845 787 une mémoire FLASH comprenant un dispositif de protection en écriture et un circuit tampon de programmation comprenant une pluralité de verrous haute tension connectés aux lignes de bits de la mémoire, chaque verrou étant prévu pour stocker un bit. La structure d'une telle mémoire permet de simuler le mode page des mémoires EEPROM tout en conservant un mode de programmation mot par mot. Toutefois, une telle mémoire comprenant une pluralité de verrous haute tension est complexe et coûteuse à réaliser en raison du nombre de verrous de programmation à prévoir.

Le document EP-A-0561271 décrit une mémoire (FMRY) en circuit intégré (CHP) comprenant une mémoire centrale de type FLASH (ARY) comporant une ensemble de verrous de programmation (DILAT, WRIT) prévu pour enregistrer un mot présenté sur l'entrée de donnée (PDB8-15) de la mémoire FLASH sans possibilité d'enregistrer simultanément plusieurs mots en parallèle, qui comprend en plus une mémoire tampon (RAM) d'une capacité suffisante pour stocker une pluralité de mots, sont la sortie est reliée à l'entrée de la mémoire FLASH (FMRY, ARY), et des moyens (CPU, SCI, I/O) pour enregistrer dabs ka mémoire tampon (RAM) une suite de mots à enregistrer dans la mémoire FLASH (FMRY, ARY) et enregistrer ensuite les uns après les autres dabs ka nenoire FLASH (FMRY, ARY), par l'intermédiaire des verrous de programmation (DILAT, WRIT), les mots préalablement enregistrer dans la mémoire tampon (RAM).

Ainsi, un autre objectif de la présente invention est de prévoir une mémoire FLASH capable de simuler le mode page sans qu'il soit nécessaire de prévoir dans une telle mémoire une rangée de verrous de programmation en nombre suffisant pour recevoir un page entière.

On connaît également, par le brevet US -A- 5 488 711, une mémoire EEPROM programmable par page comportant une mémoire cache prévue pour accélérer le processus de chargement d'une page et libérer le microprocesseur pour d'autres tâches après le déchargement de la mémoire cache dans les verrous de programmation de la mémoire EEPROM. Toutefois, une telle mémoire nécessite également, comme toutes les mémoires EEPROM programmables par page, la prévision d'un nombre élevé de verrous de programmation permettant de recevoir une page entière.

La demande internationale WO-A-97 48101 décrit en relation avec sa figure 2 une mémoire FLASH comportant une mémoire tampon. Comme précédemment, l'inconvénient de cette mémoire FLASH est de nécessiter une rangée de verrous haute tension de la taille d'une page.

Le document US-A-5,363,330 concerne un dispositif de mémoire non volatile à semi-conducteur, et le document US-A-5,986,965 enfin décrit un procédé et un dispositif pour l'écriture de données dans des circuits de mémoire non volatile, dans lesquels une mémoire à être utilisée dans un circuit intégré ayant une cellule de mémoire centrale comporte un tableau de moyens de lecture/d'écriture adaptés pour le tamponnage d'un mot appliqué à une partie d'entrée de la cellule de mémoire sans la possibilité d'enregistrer en même temps plusieurs mots parallèlement. La mémoire comporte également une partie de traitement de données adaptée à la réception et au traitement d'instructions d'effaçage et de programmation fournies à la mémoire de l'extérieur. Une mémoire tampon ayant une capacité pour stocker plusieurs mots a une sortie reliée à l'entrée de la cellule de mémoire. La mémoire comporte également des moyens pour le tamponnage d'une série de mots à stocker dans la cellule de mémoire dans la mémoire tampon et pour l'enregistrement suivant de mots stockés précédemment dans la mémoire tampon l'un après l'autre dans la cellule de mémoire, en utilisant des moyens d'écriture / de lecture.

Pour atteindre les objectifs visés, la présente invention propose une mémoire en circuit intégré selon la revendication 1 et une procédé pour enregistrer une suite de mots dans une mémoire en circuit intégré selon la revendication 8.

Des modes de réalisation avantageux et appropriés de l'invention sont l'objet des revendications dépendantes respectives.

L'idée générale de la présente invention est d'associer une mémoire tampon à une mémoire FLASH classique ne comportant qu'un nombre réduit de verrous haute tension, par exemple huit verrous, au lieu de prévoir comme cela est proposé dans l'art antérieur une rangée de verrous permettant de recevoir une page. Selon l'invention, un chargement de données dans la mémoire tampon est effectué comme s'il s'agissait d'un chargement dans la mémoire FLASH, en utilisant les bits de poids faible de l'adresse de chargement dans la mémoire FLASH. Le contenu de la mémoire tampon est ensuite transféré mot à mot dans les verrous haute tension, par programmation séquentielle de la mémoire FLASH, grâce à un système d'adressage permettant de lier les adresses appliquées à la mémoire tampon aux adresses appliquées à la mémoire FLASH.

Ces objets, caractéristiques et avantages ainsi que d'autres de la présente invention seront exposés plus en détail dans la description suivante d'un exemple de réalisation d'une mémoire intégrée selon l'invention, faite à titre non limitatif en relation avec les figures jointes, parmi lesquelles :
- les figures 1A, 1B précédemment décrites représentent schématiquement des matrices de cellules mémoire EEPROM et de cellules mémoire FLASH conventionnelles,
- la figure 2 représente sous forme de blocs la structure d'une mémoire FLASH classique,
- la figure 3 représente sous forme de bloc la structure d'une mémoire selon l'invention, et
- les figures 4A à 4F représentent divers signaux électriques intervenant dans un procédé d'enregistrement de données dans une mémoire selon l'invention.

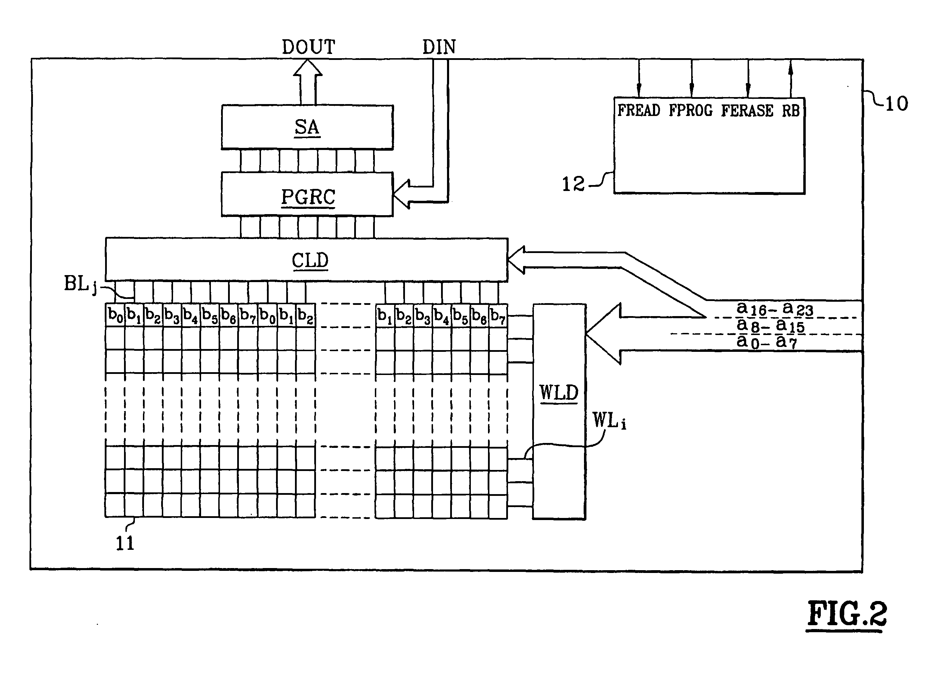

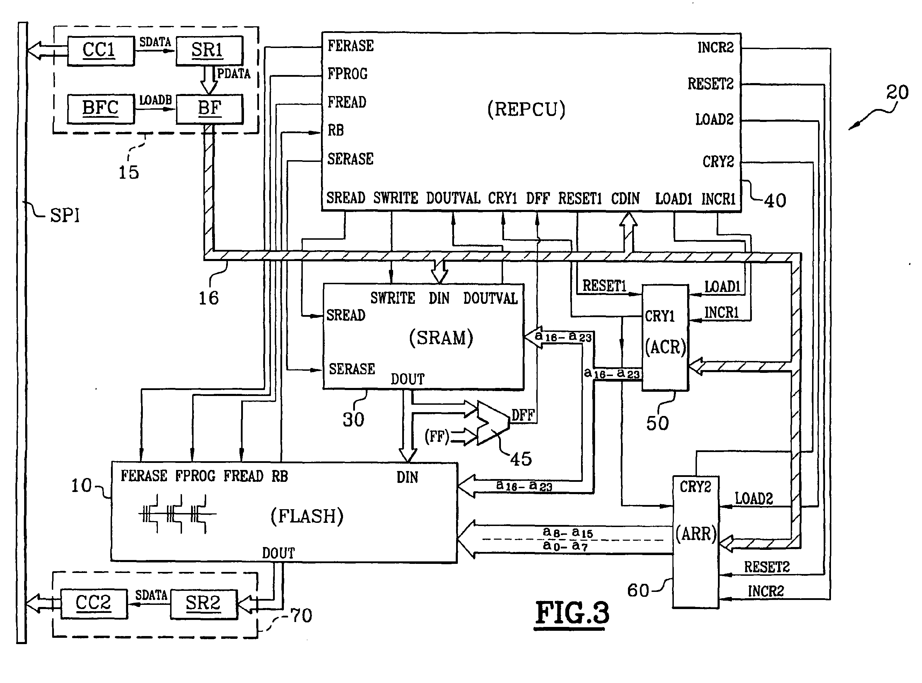

La figure 2 représente schématiquement une mémoire FLASH classique 10, programmable octet par octet et effaçable secteur par secteur. Une mémoire 20 selon l'invention, décrite plus loin en relation avec la figure 3, sera réalisée au moyen de cette mémoire 10. La mémoire 10 comprend une matrice 11 de cellules mémoire du type décrit au préambule (figure 1B), un décodeur de lignes WLD connecté aux lignes de mots WLᵢ, un décodeur de colonnes CLD connecté aux lignes de bits BLⱼ, ainsi qu'un circuit de lecture SA et un registre tampon de programmation PGRC connectés au décodeur de colonne CLD.

La matrice 11 comprend ici 256 secteurs de 256 pages chacun, chaque page comprenant 256 mots, chaque mot comprenant ici 8 cellules mémoire. La mémoire 10 reçoit sur son entrée d'adresse une adresse de 24 bits comprenant seize bits de poids fort a₀-a₇, a₈-a₁₅ et huit bits de poids faible a₁₆-a₂₃. Les bits d'adresse a₀-a₁₅ sont appliqués à un décodeur de lignes de mots WLD et les bits a₁₆-a₂₃ sont appliqués à un décodeur de colonnes CLD. Les bits de plus fort poids a₀-a₇ correspondent à l'adresse d'un secteur dans la matrice 11, les bits suivants a₈-a₁₅ correspondent à l'adresse d'une page physique dans un secteur, une page physique couvrant tous les mots d'une même ligne de mots, et les bits de plus faible poids a₁₆-a₂₃ correspondent à l'adresse d'une colonne, c'est à dire l'adresse d'un mot dans une page.

Le circuit de lecture SA délivre en parallèle, sur une sortie DOUT de la mémoire 10, les huit bits d'un mot lu dans la matrice 11. D'autre part, les huit bits d'un mot à programmer sont reçus en parallèle sur une entrée DIN de la mémoire 10 et sont appliqués au registre tampon de programmation PGRC.

Le registre PGRC comprend classiquement une série de bascules à verrouillage haute tension (non représentés), ici huit verrous ("latches") pour permettre une programmation par octet. Chaque verrou reçoit un bit du mot à programmer et délivre une haute tension de programmation Vpp lorsque le bit reçu est égal à "0" (ou "1" selon la convention choisie). La tension Vpp, de l'ordre de 5 à 6 V, se propage dans les lignes de bits correspondantes de la matrice 11 pour polariser les drains des transistors à programmer tandis qu'une autre tension Vpp de plus forte valeur est appliquée sur les grilles des transistors, comme cela a été expliqué au préambule (programmation par injection d'électrons chauds).

Ainsi, contrairement à FR 2 756 410 et aux autres documents cités au préambule, la capacité de stockage du registre PGRC est d'un mot et un seul, ici un octet.

Ces divers circuits, registres et décodeurs sont contrôlés et activés par un ensemble de circuits de commande, de commutation et de contrôle représentés schématiquement sous la forme d'un bloc 12. Le bloc 12 exécute une opération de lecture d'un octet sur réception d'un signal FREAD, exécute une opération de programmation d'un octet sur réception d'un signal FPGR, et exécute une opération d'effacement d'un secteur sur réception d'un signal FERASE. Le bloc 12 délivre un signal RB (Ready/Busy) égal à "1" pendant ces opérations, pour la synchronisation de la mémoire 10 avec des éléments externes.

Après l'effacement d'un secteur, une telle mémoire classique 10 ne peut programmer qu'un mot à la fois pour des raisons technologiques exposées au préambule. Le mot est présenté sur l'entrée DIN et le signal FPROG est appliqué à la mémoire 10.

La figure 3 représente la structure générale d'une mémoire 20 selon l'invention qui ne présente pas une telle limitation. La mémoire 20 comprend une mémoire centrale FLASH identique à celle qui vient d'être décrite, de même référence 10, ainsi que divers éléments périphériques parmi lesquels on distingue :
- en entrée, un circuit d'interface série/parallèle 15,
- un bus de données interne 16, ici un bus de huit bits,
- une mémoire tampon 30, ici une mémoire volatile de type SRAM adressable sous 8 bits,
- une unité centrale REPCU (Read Erase Program Central Unit) à logique câblée, référencée 40,
- un registre d'adresses de colonnes ACR (Address Columns Register) de type compteur, référencé 50,
- un registre d'adresses de lignes de mots ARR (Address Rows Register) référencé 60, également de type compteur, et
- en sortie, un circuit d'interface parallèle/série 70.

Le circuit d'interface 15 est connecté ici à un bus série de type SPI et convertit des données reçues sous forme série SDATA en données parallèles PDATA. Ces données comprennent ici des instructions, des adresses, ainsi que des mots devant être enregistrés dans la mémoire centrale 10. Le circuit d'interface 15 comprend un circuit CC1 de mise en forme des données série (Conditioning Circuit), connecté au bus SPI, un registre à décalage SR1 à entrée série et sortie parallèle (Shift Register), un tampon BF (Buffer) et un circuit BFC de contrôle de trame (Bus Frame Control). Le circuit BFC gère la synchronisation entre l'horloge du bus interne 16 (par exemple 2,5 MHz) et l'horloge du bus SPI (par exemple 20 MHz). Les données SDATA envoyées par l'intermédiaire du bus SPI sont mises en forme par le circuit CC1 et appliquées au registre SR1. Ce dernier délivre des données parallèles PDATA à l'entrée du tampon BF, dont la sortie est connectée au bus interne 16. Le tampon BF délivre les données PDATA sur le bus interne 16 sur réception d'une instruction LOAD délivrée par le circuit de synchronisation BFC.

L'entrée de données DIN de la mémoire centrale FLASH 10, qui est connectée à l'intérieur de la mémoire centrale 10 au registre tampon de programmation PGRC décrit plus haut en relation avec la figure 2, est connectée à la sortie DOUT de la mémoire tampon 30, tandis que l'entrée de données DIN de la mémoire tampon est connectée au bus interne 16. Le registre 60 est connecté en entrée au bus 16 et délivre seize bits d'adresse de poids fort a₀-a₇, a₈-a₁₅ appliqués sur l'entrée d'adresse de la mémoire centrale 10. Le registre 50, également connecté au bus 16, délivre huit bits d'adresse de poids faible a₁₆-a₂₃ appliqués sur l'entrée d'adresse de la mémoire centrale 10, où ils se combinent avec les bits a₀-a₁₅ pour former l'adresse complète a₀-a₂₃ d'un mot.

L'unité centrale 40 contrôle ces divers éléments et comporte une entrée CDIN connectée au bus 16 pour recevoir, décoder et exécuter des instructions de haut niveau, reçues par l'intermédiaire du bus externe SPI et envoyées sur le bus interne 16 par le circuit d'interface 15. Ces instructions comprennent notamment :
1) une instruction d'effacement d'un secteur de la mémoire centrale 10, comprenant un code opération et l'adresse a₀-a₇ du secteur à effacer, se présentant par exemple sous le format suivant :

| | |
|---|---|
| CODE_{ERASE} | a₀-a₇ |

2) une instruction de lecture d'un ou plusieurs mot dans la mémoire centrale 10, comprenant un code opération, l'adresse a₀-a₂₃ du premier mot à lire et le nombre n de mots à lire, codé ici sur 8 bits (soit la possibilité de lire l'ensemble d'une page de 256 mots), se présentant par exemple sous le format suivant :

| | | | | |
|---|---|---|---|---|
| CODE_{READ} | a₀-a₇ | a₈-a₁₅ | a₁₆-a₂₃ | n |

3) une instruction d'enregistrement d'une suite de mots dans une page de la mémoire centrale 10, comprenant un code opération, une adresse a₀-a₂₃ de départ et les mots B₁ à Bₘ à enregistrer, "m" pouvant aller de 1 (programmation d'un seul mot B₁) à 256 (programmation de toute une page). Cette instruction se présente par exemple sous le format suivant :

| | | | | | | | | |
|---|---|---|---|---|---|---|---|---|
| CODE_{PGR} | a₀-a₇ | a₈-a₁₅ | a₁₆-a₂₃ | B₁ | B₂ | B₃ | ··· | Bₘ |

L'exécution de ces diverses instructions, ainsi que d'autres éventuelles, est assurée par l'unité centrale 40 au moyen de divers signaux de commande et de contrôle, parmi lesquels on distingue :

### Signaux de commande émis :

**FERASE :** signal d'effacement d'un secteur de la mémoire centrale 10,
**FPROG :** signal de programmation d'un mot (octet) dans la mémoire centrale 10,
**FREAD :** signal de lecture d'un mot dans la mémoire centrale 10,
**SWRITE :** signal d'écriture d'un mot dans la mémoire tampon 30,
**SERASE :** signal d'effacement de la mémoire tampon 30
**SREAD :** signal de lecture d'un mot dans la mémoire tampon 30,
**LOAD1 :** signal de chargement dans le registre 50 d'une adresse présente sur le bus interne 16,
**INCR1 :** signal d'incrémentation du registre 50,
**RESET1 :** signal de remise à zéro du registre 50,
**LOAD2 :** signal de chargement dans le registre 60 d'une **adresse** présente sur le bus interne 16,
**INCR2 :** signal d'incrémentation du registre 60, et
**RESET2 :** signal de remise à zéro du registre 60,

### Signaux de contrôle reçus :

**RB** (Ready/Busy) : signal de synchronisation envoyé par la mémoire centrale 10, porté à "1" pendant des opérations de lecture, programmation ou effacement,
**DOUTVAL** : signal envoyé par la mémoire tampon 30 et porté à "1" quand la sortie DOUT de la mémoire est valide, après application du signal de lecture SREAD,
**CRY1** (Carry) : signal de dépassement de capacité du registre 50, également appliqué sur l'entrée d'incrémentation du registre 60,
**CRY2** (Carry) : signal de dépassement de capacité du registre 60.

Selon l'invention, l'exécution de l'instruction d'effacement d'un secteur de la mémoire centrale 10 comprend une étape de décodage du code opération CODE_{ERASE} par l'unité centrale 40, une étape de chargement de l'adresse a₀-a₇ du secteur à effacer dans le registre 60, et une étape d'application du signal FERASE à la mémoire centrale 10.

L'exécution de l'instruction de lecture d'un ou plusieurs mots dans la mémoire centrale 10 comprend une étape de décodage du code opération CODE_{READ}, une étape de chargement des bits d'adresse a₀-a₁₅ dans le registre 60, une étape de chargement des bits d'adresse a₁₆-a₂₃ dans le registre 50, et une étape d'application de "n" signaux de lecture FREAD à la mémoire centrale 10. Le nombre "n" détermine le nombre de cycles de lecture (signal FREAD) à appliquer à la mémoire centrale 10 avec incrémentation du registre d'adresses 50 avant chaque nouvelle lecture. Les données délivrées par la mémoire centrale 10 sont envoyées sur le bus SPI par le circuit parallèle/série 70. Ce dernier comprend un registre à décalage SR2 dont l'entrée est connectée à la sortie parallèle DOUT de la mémoire centrale 10, délivrant des données série SDATA au bus SPI par l'intermédiaire d'un circuit CC2 de conditionnement des signaux de sortie.

L'exécution d'une instruction d'enregistrement d'une suite de mots B₁-Bₘ dans une page de la mémoire centrale 10 (qui est impérativement précédée d'une instruction d'effacement du secteur concerné) est assurée par l'unité centrale 40 en trois phases parmi lesquelles on distingue :
i) une phase de lecture de l'instruction, comprenant le décodage du code opération CODE_{PGR}, le chargement des bits d'adresse a₀-a₁₅ dans le registre 60 et le chargement des bits d'adresse a₁₆-a₂₃ dans le registre 50,
ii) une phase d'enregistrement des mots B₁ à Bₘ dans la mémoire tampon 30, comprenant une pluralité d'étapes élémentaires d'enregistrement de chaque mot reçu sur le bus interne 16, effectuées au moyen du signal FWRITE, et
iii) une phase de lecture des mots B₁ à Bₘ enregistrés dans la mémoire tampon 30 et d'enregistrement de ces mots dans la mémoire centrale 10, comprenant une pluralité d'étapes élémentaires de lecture de chaque mot, effectuées au moyen du signal SREAD, et d'enregistrement dans la mémoire centrale 10 du mot lu, effectuées au moyen du signal FPROG.

Vu de l'extérieur, la phase iii) est transparente pour l'utilisateur et la mémoire 20 selon l'invention fonctionne comme une mémoire EEPROM à programmation page par page. La mémoire 20 présente ainsi les avantages d'une mémoire EEPROM en termes de souplesse d'emploi et les avantages d'une mémoire FLASH en termes de densité d'intégration. Il doit être noté ici que la surface de silicium occupée par les divers éléments ajoutés à la mémoire centrale 10 est négligeable au regard de la surface occupée par la mémoire centrale 10 elle-même.

Pour réduire le plus possible l'encombrement et la complexité de ces éléments périphériques, la présente invention prévoit un procédé avantageux permettant de réaliser les phases ii) et iii) sans qu'il soit nécessaire de prévoir un registre de stockage de l'adresse de départ fournie par l'instruction, ni de prévoir un compteur du nombre de mots enregistrés dans la mémoire tampon 30. Ce procédé repose tout d'abord sur deux arrangements d'ordre matériel. Le premier arrangement consiste à appliquer sur l'entrée d'adresse de la mémoire tampon 30 les huit bits d'adresse de poids faible a₁₆-a₂₃ délivrés par le registre 50, qui représentent l'adresse d'un mot (colonne) dans une page de la mémoire centrale 10. Le second arrangement consiste à prévoir un moyen pour détecter à la sortie de la mémoire tampon 30 la présence d'un mot ne comprenant que des bits à "1", correspondant à un mot effacé dans la mémoire centrale 10 (les cellules effacées d'une mémoire FLASH étant par convention à "1", comme indiqué au préambule). Comme illustré sur la figure 3, ce moyen prend par exemple la forme d'un comparateur logique 45 recevant sur une première entrée la sortie de la mémoire tampon 30 et sur une deuxième entrée une consigne égale à "FF" en notation hexadécimale, soit huit bits à "1". Le comparateur 45 délivre un signal DFF, qui est à "1" quand la sortie de la mémoire tampon est égale à "FF".

Ainsi, lorsque la phase ii) commence, la mémoire tampon reçoit 30 sur son entrée d'adresse l'adresse de poids faible a₁₆-a₂₃ fournie par l'instruction d'enregistrement, stockée par le registre 50. Cette adresse peut ne pas être nulle, de sorte que l'enregistrement des mots B₁-Bₘ dans la mémoire tampon 30 peut commencer en tout point de la mémoire tampon défini par cette adresse. A chaque nouvel enregistrement, le registre 50 est incrémenté d'une unité jusqu'à ce que le dernier mot soit enregistré. Au terme de la phase ii) le contenu de la mémoire tampon 30 est ainsi l'image du contenu que devra présenter la page sélectionnée de la mémoire centrale 10 au terme de la phase iii). L'adresse de départ a₁₆-a₂₃ est perdue puisque le registre 50 a été incrémenté "n" fois et qu'aucun registre de conservation de l'adresse initiale n'a été prévu.

Selon l'invention, la phase iii) consiste à lire tout le contenu de la mémoire tampon 30 à partir de l'adresse zéro (obtenue en appliquant au registre 50 le signal RESET1), jusqu'à ce que le registre 50 émette le signal de dépassement CRY1. A chaque lecture de la mémoire tampon, le mot binaire présent sur la sortie DOUT est enregistré dans la mémoire centrale 10 s'il est différent de "FF" ou n'est pas enregistré s'il est égal à "FF". En effet, le secteur concerné de la mémoire centrale 10 a été préalablement effacé et ne contient que des mots égaux à "FF". Il est donc inutile de déclencher une opération de programmation, qui ne permet que d'écrire des "0", si le mot à enregistrer est égal à "FF".

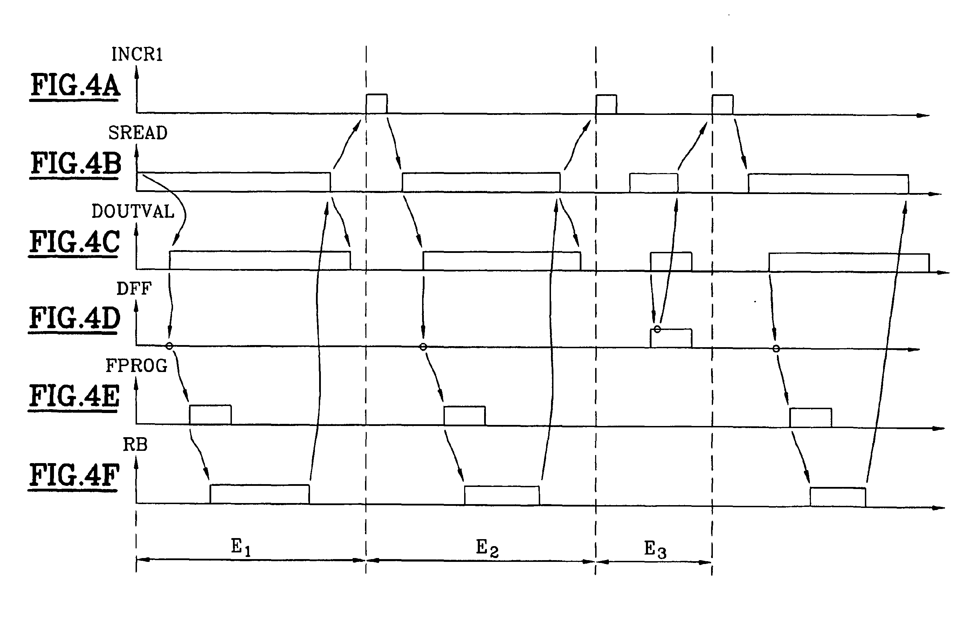

Pour fixer les idées, les figures 4A à 4F représentent quatre premières étapes de la phase iii) selon l'invention. La première étape E1 est déclenchée après l'enregistrement des mots reçus B₁-Bₘ dans la mémoire tampon 30, et comprend les étapes suivantes :
- lire la mémoire tampon en portant le signal SREAD à "1" (figure 4B)
- attendre que la sortie de la mémoire tampon soit valide (signal DOUTVAL à "1", figure 4C),
- vérifier que le mot délivré par la mémoire tampon est différent de "FF" (signal DFF à "0", figure 4D),
- si le mot est différent de "FF", enregistrer le mot dans la mémoire centrale 10 (signal de programmation FPROG, figure 4E)
- attendre que l'opération de programmation soit terminée (signal RB à "0" , figure 4F), puis relâcher le signal de lecture SREAD (figure 4B, le signal DOUTVAL passe ensuite à "0" en figure 4C) et passer à l'étape suivante E2.

L'étape suivante E2 est identique à l'étape E1 mais comprend une étape préliminaire d'incrémentation du registre 50 (signal INCR1 à "1", figure 4A).

L'étape E3 telle que représentée sur les figures 4A à 4F illustre le cas où la sortie de la mémoire tampon délivre un mot égal à "FF". Dans ce cas, le signal DFF passe à "1" (figure 4D) et le signal FPROG n'est pas appliqué à la mémoire centrale 10. L'unité centrale passe directement à l'étape suivante, qui est ici identique à l'étape E2.

Ainsi, après la première étape E1, la phase iii) du procédé selon l'invention comprend une succession d'étapes du type E2 ou d'étapes du type E3. Si, par exemple, le premier mot a été enregistré dans la mémoire tampon à l'adresse 00001111, il y aura 256 étapes de lecture de type E3 qui seront effectuées sans déclenchement d'une opération de programmation dans la mémoire centrale 10.

Au terme de la phase iii), l'unité centrale efface en principe la mémoire tampon au moyen du signal SERASE et efface les registres 50, 60 au moyen des signaux RESET1, RESET2. Toutefois, avant de procéder à cet effacement, une variante avantageuse du procédé de l'invention comprend une étape finale de vérification, consistant à effectuer une lecture parallèle de la mémoire centrale 10 et de la mémoire tampon 30 et à comparer les données délivrées par chacune des mémoires. Dans ce cas, le registre 50 est remis à zéro et l'unité centrale 40 balaye, en incrémentant le registre 50, toutes les adresses de poids faible a₁₆-a₂₃ se trouvant à l'intérieur de la page définie par les bits d'adresse de poids fort a₀-a₁₅ stockés dans le registre 60. Les mots lus en parallèle dans les deux mémoires 10, 30 sont par exemple appliqués sur les deux entrées d'un comparateur 8 bits (non représenté) dont la sortie pilote une bascule. La sortie de la bascule passe à "1" si deux mots lus en parallèle ne sont pas identiques. Cette procédure de vérification permet par exemple à la mémoire 20 d'envoyer un signal d'erreur signalant à l'utilisateur que l'opération d'enregistrement est entachée d'erreur et doit être recommencée.

Il apparaîtra clairement à l'homme de l'art que la présente invention est susceptible de diverses autres variantes de réalisation et perfectionnements.

En particulier, bien que l'on ait indiqué plus haut que la mémoire tampon 30 reçoit les bits d'adresse de poids faible a₁₆-a₂₃ définissant l'adresse d'un mot dans une page, il est envisageable d'étendre le procédé de l'invention à l'enregistrement de tout un secteur (voire plus) en appliquant les 16 derniers bits d'adresse a₈₋a₂₃ à la mémoire tampon. En pratique, un compromis devra être fait entre la capacité de stockage de la mémoire tampon, l'encombrement et le prix de revient de la mémoire 20.

Inversement, la mémoire tampon 30 peut aussi recevoir sur son entrée d'adresse une partie seulement des bits d'adresse de poids faible a₁₆-a₂₃, ce qui revient à définir un mode de programmation par page dans lequel les pages sont des pages logiques de taille inférieure aux pages physiques de la mémoire centrale 10.

Egalement, la mémoire tampon 30 peut comporter, en sus des entrées d'adresse recevant les bits a₁₆-a₂₃ (ou plus), des entrées d'adresse de poids fort contrôlées par l'unité centrale 40, permettant de délimiter dans la mémoire tampon des pages supplémentaires pouvant servir à stocker des données de fonctionnement, des paramètres de la mémoire 20, ou toute autre donnée utile.

De façon générale, on a décrit dans ce qui précède une mémoire 20 présentant une flexibilité que l'on ne rencontre dans l'art antérieur qu'avec des mémoires EEPROM. La mémoire 20 qui vient d'être décrite comprend quatre caractéristiques essentielles qui peuvent être dissociées les unes des autres mais ont été combinées dans le mode de réalisation décrit pour l'obtention d'une mémoire FLASH pouvant remplacer une mémoire EEPROM conventionnelle à entrée/sortie série et à programmation par page. Pour résumer, ces caractéristiques sont les suivantes :
1) la prévision d'une interface série/parallèle complète (codes opérations, adresses et données) ou partielle (données uniquement)
2) la prévision d'une mémoire tampon permettant de simuler la programmation en mode page des mémoires EEPROM,
3) la prévision d'une unité centrale exécutant des instructions de programmation ou de lecture de haut niveau (ces instructions pourraient en effet être pilotées de l'extérieur),
4) la prévision d'un procédé de simulation du mode page ne nécessitant pas l'utilisation d'un registre de stockage de l'adresse de départ, pour réduire la surface de silicium nécessaire à l'implémentation des éléments périphériques.

Bien que la structure de l'unité centrale n'ait pas été décrite dans ce qui précède dans un souci de simplicité, la réalisation pratique d'une telle unité centrale sous la forme d'un séquenceur à logique câblée est en soi à la portée de l'homme de l'art au regard des informations divulguées dans la présente demande. Il en est de même pour les circuits d'interface 15, 70, dont la réalisation dépend en pratique du type de bus série auquel la mémoire 20 selon l'invention doit être raccordée (RS232, I2C, SPI...).

## Revendications

1. Mémoire (20) en circuit intégré comprenant une mémoire centrale de type FLASH (10) programmée par injections d'electrons chauds comportant un ensemble de verrous de programmation (PGRC) prévu pour enregistrer un mot présenté sur l'entrée de données (DIN) de la mémoire FLASH (10) et une mémoire tampon (30) d'une capacité suffisante pour stocker une pluralité de mots, dont la sortie est reliée à l'entrée de la mémoire FLASH (10), et des moyens (40, 50, 60) pour enregistrer dans la mémoire tampon (30) une suite de mots et enregistrer ensuite lesdits mots les uns après les autres dans la mémoire FLASH (10), par l'intermédiaire des verrous de programmation (PGRC), **caractérisée en ce que** les moyens pour enregistrer sont agencés pour :
- enregistrer la suite de mots dans la mémoirê tampon en appliquant tout d'abord à la mémoire tampon une adresse comprenant au moins N premiers bits (a₁₆-a₂₃) égaux aux N bits de poids faible d'une adresse d'enregistrement dans la mémoire FLASH du premier mot de la suite de mots, l'adresse appliquée à la mémoire tampon étant incrémentée après chaque enregistrement d'un mot, puis
- enregistrer lesdits mots les uns après les autres dans la mémoire FLASH, en appliquant à la mémoire FLASH (10) une adresse comprenant M bits de poids fort (a₀-a₁₅) et N bits de poids faible (a₁₆-a₂₃), les N bits de poids faible correspondent à l'adresse d'un mot dans une page physique de la mémoire FLASH, et à la mémoire tampon (30) une adresse comprenant les N bits de poids faible (a₁₆-a₂₃) de l'adresse appliquée à la mémoire FLASH (10), l'adresse appliquée à la mémoire FLASH étant incrémentée après chaque enregistrement d'un mot.

2. Mémoire selon la revendication 1, **caractérisée en ce que** une page physique comprend tous les mots présents dans une ligne de mots de la mémoire FLASH.

3. Mémoire selon l'une des revendications 1 à 2, **caractérisée en ce qu'**elle comprend des moyens pour exécuter une instruction d'enregistrement d'une pluralité de mots comprenant un code de l'instruction (CODE_{PGR}), une adresse de départ dans la mémoire FLASH et la suite de mots à enregistrer (B₁-Bₘ).

4. Mémoire selon l'une des revendications 1 à 3, **caractérisée en ce qu'**elle comprend un compteur d'adresse (50) dont la sortie est connectée à l'entrée d'adresse de la mémoire tampon et aux entrées d'adresse de plus faible poids de la mémoire FLASH.

5. Mémoire selon la revendication 4, **caractérisée en ce qu'**elle comprend des moyens (40,60) pour
i) charger dans le compteur d'adresse (50) les N bits de poids faible de l'adresse d'enregistrement dans la mémoire FLASH du premier mot de la suite de mots,
ii) enregistrer le premier mot reçu dans la mémoire tampon (30) et enregistrer les mots suivants en incrémentant le compteur d'adresse (50) à chaque nouvel enregistrement,
iii) mettre à zéro le compteur d'adresse (50),
iv) appliquer les M bits de poids fort de l'adresse d'enregistrement du premier mot sur l'entrée d'adresse de la mémoire FLASH,
v) lire la mémoire tampon (30) à l'adresse courante délivrée par le compteur d'adresse (50),
vi) si la valeur du mot lu dans la mémoire tampon est différente de la valeur d'un mot effacé (FF),
appliquer à la mémoire FLASH un signal de programmation (FPGR),
vii) incrémenter le compteur d'adresse (50) et répéter les étapes v) et vi) jusqu'à la dernière adresse pouvant être délivrée par le compteur d'adresse avant débordement de ce dernier (CRY1).

6. Mémoire selon l'une des revendications 1 à 5, **caractérisée en ce qu'**elle comprend un circuit d'interface série/parallèle (15, 70) au moins pour recevoir des mots à enregistrer dans la mémoire FLASH par l'intermédiaire de la mémoire tampon.

7. Mémoire selon la revendication 6, **caractérisée en ce qu'**elle comprend des moyens de vérification d'écriture dans la mémoire FLASH agencés pour, après transfert des mots dans la mémoire FLASH et avant effacement de la mémoire tampon, comparer les mots enregistrés dans la mémoire FLASH et les mots enregistrés dans la mémoire tampon.

8. Procédé pour enregistrer une suite de mots dans une mémoire (20) en circuit intégré comprenant une mémoire centrale de type FLASH (10) programmée par injections d'électrons chauds comportant un ensemble de verrous de programmation (PGRC) prévu pour enregistrer un mot présenté sur l'entrée de données (DIN) de la mémoire FLASH (10) le procédé comprenant les étapes suivants :
- prévoir une mémoire tampon (30) d'une capacité suffisante pour stocker la pluralité de mots, et connecter la sortie de la mémoire tampon à l'entrée de la mémoire FLASH,
- envoyer la suite de mots à la mémoire,
- enregistrer dans la mémoire tampon la suite de mots envoyés à la mémoire, puis
- enregistrer lesdits mots les uns après les autres dans la mémoire FLASH, par l'intermédiaire des verrous de programmation,
le procédé **caractérisé en ce qu'**il comprend les étapes consistant à :
- enregistrer la suite de mots dans la mémoire tampon (30) en appliquant tout d'abord à la mémoire tampon une adresse comprenant au moins N premiers bits (a₁₆-a₂₃) égaux aux N bits de poids faible d'une adresse d'enregistrement dans la mémoire FLASH du premier mot de la suite de mots, l'adresse appliquée à la mémoire tampon (30) étant incrémentée après chaque enregistrement d'un mot, - enregistrer lesdits mots les uns après les autres dans la mémoire FLASH en appliquant à la mémoire FLASH (10) une adresse comprenant M bits de poids fort (a₀-a₁₅) et N bits de poids faible (a₁₆-a₂₃), les N bits de poids faible correspondent à l'adresse d'un mot dans uns page physique de la mémoire FLASH, et à la mémoire tampon (30) une adresse comprenant les N bits de poids faible (a₁₆-a₂₃) de l'adresse appliquée à la mémoire FLASH, l'adresse appliquée à la mémoire FLASH étant incrémentée après chaque enregistrement d'un mot.

9. Procédé selon la revendication 8, dans lequel les mots sont reçus sous forme de données série (SDATA) et les données série sont reconstituées en mots (PDATA) envoyés à l'entrée de la mémoire tampon (30).

10. Procédé selon l'une des revendications 8 ou 9, **caractérisé en ce qu'**il comprend les étapes consistant à:
a) appliquer sur l'entrée d'adresse de la mémoire tampon une adresse de lecture comprenant au moins N premiers bits (a₁₆-a₂₃) et lire un mot dans la mémoire tampon (30),
b) appliquer sur l'entrée d'adresse de la mémoire FLASH une adresse comprenant M bits de poids fort (a₀-a₁₅) d'une adresse d'enregistrement dans la mémoire FLASH du premier mot de la suite de mots, et N bits de poids faible identiques aux N premiers bits de l'adresse de lecture,
c) si la valeur du mot lu est différente de la valeur d'un mot effacé (FF) appliquer à la mémoire FLASH un signal d'enregistrement du mot lu,
les étapes a) b) c) étant répétées en commençant par une adresse de lecture comprenant au moins N premiers bits égaux à "0" jusqu'à atteindre par incrémentations successives une adresse de lecture comprenant N premiers bits égaux à "1".

11. Procédé selon l'une des revendications 8 à 10, comprenant une étape de vérification consistant à répéter les étapes d) e) f) mentionnées ci-après en commençant par une adresse de lecture comprenant N premiers bits égaux à "O" jusqu'à atteindre par incrémentations successives une adresse de lecture comprenant N premiers bits égaux à "1"
d) appliquer sur l'entrée d'adresse de la mémoire tampon l'adresse de lecture, et lire un mot dans la mémoire tampon,
e) appliquer sur l'entrée d'adresse de la mémoire FLASH une adresse comprenant les M bits de poids fort d'une adresse d'enregistrement dans la mémoire FLASH du premier mot de la suite de mots et N bits de poids faible identiques aux N premiers bits de l'adresse de lecture, et lire un mot dans la mémoire FLASH, et
f) comparer le mot lu dans la mémoire FLASH et le mot lu dans la mémoire tampon.

## Claims

1. An integrated circuit memory (20) comprising a main memory of the FLASH type (10) programmed by hot electron injection comprising a set of programming latches (PGRC) provided to record a word presented at the data input (DIN) of the FLASH memory (10) and a buffer memory (30) with a sufficient capacity to store a plurality of words, the output of which is coupled to the input of the FLASH memory (10), and means (40, 50, 60) for recording, in the buffer memory (30), a series of words and for then recording, in the FLASH memory (10), the words one after the other by means of the programming latches (PGRC), **characterised in that** the recording means are designed to:
- record the series of words in the buffer memory by first applying to the buffer memory an address comprising at least N first bits (a₁₆-a₂₃) equal to N least significant bits of a record address in the FLASH memory of the first word of the series of words, the address applied to the buffer memory being incremented after each recording of a word, then to
- record said words one after the other in the FLASH memory by applying to the FLASH memory (10) an address comprising M most significant bits (a₀-a₁₅) and N least significant bits (a₁₆-a₂₃), the N least significant bits corresponding to the address of a word in a physical page of the FLASH memory, and by applying to the buffer memory (30) an address comprising the N least significant bits (a₁₆-a₂₃) of the address applied to the FLASH memory (10), the address applied to the FLASH memory being incremented after each recording of a word.

2. The memory according to claim 1, **characterised in that** a physical page comprises all the words present in a line of words of the FLASH memory.

3. The memory according to either claim 1 or claim 2, **characterised in that** it comprises means for carrying out an instruction to record a plurality of words comprising an instruction code (CODE_{PGR}), a starting address in the FLASH memory and the series of words to be recorded (B₁-Bₘ).

4. The memory according to any one of claims 1 to 3, **characterised in that** it comprises an address counter (50) of which the output is connected to the address input of the buffer memory and to the lesser significant address inputs of the FLASH memory.

5. The memory according to claim 4, **characterised in that** it comprises means (40, 60) for
i) loading into the address counter (50) the N least significant bits of the record address in the FLASH memory of the first word of the series of words,
ii) recording the first word received in the buffer memory (30) and recording the following words by incrementing the address counter (50) with each new recording,
iii) clearing the address counter (50),
iv) applying the M most significant bits of the record address of the first word to the address input of the FLASH memory,
v) reading the buffer memory (30) at the current address delivered by the address counter (50),
vi) if the value of the word read in the buffer memory is different from the value of an erased word (FF), applying to the FLASH memory a programming signal (FPGR),
vii) incrementing the address counter (50) and repeating steps v) and vi) as far as the last address which can be delivered by the address counter before it becomes full (CRY1).

6. The memory according to any one of claims 1 to 5, **characterised in that** it comprises a serial/parallel interface circuit (15, 70) at least for receiving words to be recorded in the FLASH memory by means of the buffer memory.

7. The memory according to claim 6, **characterised in that** it comprises means for checking the writing into the FLASH memory, said means being designed, after transfer of words into the FLASH memory and before erasing of the buffer memory, to compare the words recorded in the FLASH memory and the words recorded in the buffer memory.

8. A method for recording a series of words in an integrated circuit memory (20) comprising a main memory of the FLASH type (10) programmed by hot electron injection comprising a set of programming latches (PGRC) provided to record a word presented at the data input (DIN) of the FLASH memory (10), said method comprising the following steps
- providing a buffer memory (30) with a sufficient capacity to store the plurality of words, and connecting the output of the buffer memory to the input of the FLASH memory,
- sending the series of words to the memory,
- recording in the buffer memory the series of words sent to the memory, then
- recording, in the FLASH memory, said words one after the other by means of the programming latches,
said method being **characterised in that** it comprises the following steps:
- recording the series of words in the buffer memory (30) by first applying to the buffer memory an address comprising at least N first bits (a₁₆-a₂₃) equal to N least significant bits of a record address in the FLASH memory of the first word of the series of words, the address applied to the buffer memory (30) being incremented after each recording of a word,
- recording said words one after the other in the FLASH memory by applying to the FLASH memory (10) an address comprising M most significant bits (a₀-a₁₅) and N least significant bits (a₁₆-a₂₃), the N least significant bits corresponding to the address of a word in a physical page of the FLASH memory, and by applying to the buffer memory (30) an address comprising the N least significant bits (a₁₆-a₂₃) of the address applied to the FLASH memory, the address applied to the FLASH memory being incremented after each recording of a word.

9. The method according to claim 8, wherein the words are received in the form of serial data (SDATA) and the serial data are recreated into words (PDATA) sent to the input of the buffer memory (30).

10. The method according to either claim 8 or claim 9, **characterised in that** it comprises the following steps:
a) applying to the address input of the buffer memory a read address comprising at least N first bits (a₁₆-a₂₃) and reading a word in the buffer memory (30),
b) applying to the address input of the FLASH memory an address comprising M most significant bits (a₀-a₁₅) of a record address in the FLASH memory of the first word of the series of words, and N least significant bits identical to the N first bits of the read address,
c) if the value of the read word is different from the value of an erased word (FF), applying to the FLASH memory a record signal of the read word,
steps a), b) and c) being repeated, starting with a read address comprising at least N first bits equal to "0", until reaching by successive increments a read address comprising N first bits equal to "1".

11. The method according to any one of claims 8 to 10, comprising a verification step consisting of repeating the above-mentioned steps d), e) and f), starting with a read address comprising N first bits equal to "0", until reaching by successive increments a read address comprising N first bits equal to "1"
d) applying to the address input of the buffer memory the read address, and reading a word in the buffer memory,
e) applying to the input address of the FLASH memory an address comprising the M most significant bits of a record address in the FLASH memory of the first word of the series of words and N least significant bits identical to the N first bits of the read address, and reading a word in the FLASH memory, and
f) comparing the word read in the FLASH memory and the word read in the buffer memory.

## Patentansprüche

1. Integrierter-Schaltkreis-Speicher (20), aufweisend einen Hauptspeicher des FLASH-Typs (10), der durch Injizieren heißer Elektronen programmiert wird, aufweisend einen Satz von Programmier-Signalspeichern (PGRC), der vorgesehen ist, um ein sich am Dateneingang (DIN) des FLASH-Speichers (10) befindendes Wort zu speichern, und einen Pufferspeicher (30) mit einer Kapazität, die ausreicht, um eine Mehrzahl von Wörtern zu speichern, dessen Ausgang mit dem Eingang des FLASH-Speichers (10) verbunden ist, und Mittel (40, 50, 60), um in dem Pufferspeicher (30) eine Wortfolge zu speichern und anschließend mittels der Programmier-Signalspeicher (PGRC) die Wörter nacheinander in dem FLASH-Speicher (10) zu speichern, **dadurch gekennzeichnet, dass** die Speichermittel eingerichtet sind, um:
- die Wortfolge in dem Pufferspeicher zu speichern, wobei zunächst an den Pufferspeicher eine Adresse angelegt wird, die mindestens N erste Bits (a₁₆-a₂₃) aufweist, die gleich den N Bits mit geringer Signifikanz einer Speicheradresse in dem FLASH-Speicher des ersten Wortes der Wortfolge sind, wobei die an den Pufferspeicher angelegte Adresse nach jedem Speichern eines Wortes inkrementiert wird, und um anschließend
- die Wörter nacheinander in dem FLASH-Speicher zu speichern, wobei an den FLASH-Speicher (10) eine Adresse angelegt wird, die M Bits mit hoher Signifikanz (a₀-a₁₅) und N Bits mit geringer Signifikanz (a₁₆ bis a₂₃) aufweist, wobei die N Bits mit geringer Signifikanz der Adresse eines Wortes auf einer physikalischen Seite des FLASH-Speichers entsprechen, und an den Pufferspeicher (30) eine Adresse angelegt wird, die die N Bits mit geringer Signifikanz (a₁₆ bis a₂₃) der an den FLASH-Speicher (10) angelegten Adresse aufweist, wobei die an den FLASH-Speicher angelegte Adresse nach jedem Speichern eines Wortes inkrementiert wird.

2. Speicher gemäß Anspruch 1, **dadurch gekennzeichnet, dass** eine physikalische Seite alle Wörter aufweist, die sich in einer Wortleitung des FLASH-Speichers befinden.

3. Speicher gemäß einem der Ansprüche 1 bis 2, **dadurch gekennzeichnet, dass** er Mittel aufweist, um einen Befehl zum Speichern einer Mehrzahl von Wörtern auszuführen, aufweisend einen Befehlscode (CODE_{PGR}), eine Adresse zum Starten in dem FLASH-Speicher und die zu speichernde Wortfolge (B₁-Bₘ).

4. Speicher gemäß einem der Ansprüche 1 bis 3, **dadurch gekennzeichnet, dass** er einen Adresszähler (50) aufweist, dessen Ausgang mit dem Adressen-Eingang des Pufferspeichers und mit den Geringste-Signifikanz-Adresse-Eingängen des FLASH-Speichers verbunden ist.

5. Speicher gemäß Anspruch 4, **dadurch gekennzeichnet, dass** er Mittel (40, 60) aufweist, um:
i) in den Adresszähler (50) die N Bits mit geringer Signifikanz der Speicheradresse in dem FLASH-Speicher des ersten Wortes der Wortfolge zu laden,
ii) das erste empfangene Wort in dem Pufferspeicher (30) zu speichern und die nachfolgenden Wörter zu speichern, wobei der Adresszähler (50) bei jedem neuen Speichern inkrementiert wird,
iii) den Adresszähler (50) auf Null zu setzen,
iv) die M Bits mit hoher Signifikanz der Speicheradresse des ersten Wortes an den Adressen-Eingang des FLASH-Speichers anzulegen,
v) den Pufferspeicher (30) an der aktuellen Adresse, die von dem Adresszähler (50) ausgegeben wird, zu lesen,
vi) wenn sich der Wert des gelesenen Wortes in dem Pufferspeicher von dem Wert eines gelöschten Wortes (FF) unterscheidet, ein Programmiersignal (FPGR) an den FLASH-Speicher anzulegen,
vii) und den Adresszähler (50) zu inkrementieren und die Schritte v) und vi) bis zu der letzten Adresse zu wiederholen, die von dem Adresszähler ausgegeben werden kann, bevor dieser überlastet wird (CRY1).

6. Speicher gemäß einem der Ansprüche 1 bis 5, **dadurch gekennzeichnet, dass** er einen Serielle-/Parallel-Schnittstelle-Schaltkreis (15, 70) aufweist, um zumindest mittels des Pufferspeichers in dem FLASH-Speicher zu speichernde Wörter zu empfangen.

7. Speicher gemäß Anspruch 6, **dadurch gekennzeichnet, dass** er Schreib-Überprüfungsmittel in dem FLASH-Speicher aufweist, die eingerichtet sind, um nach dem Übertragen der Wörter in den FLASH-Speicher und vor dem Löschen des Pufferspeichers die in dem FLASH-Speicher gespeicherten Wörter mit den in dem Pufferspeicher gespeicherten Wörtern zu vergleichen.

8. Verfahren zum Speichern einer Wortfolge in einem Integrierter-Schaltkreis-Speicher (20), der einen Hauptspeicher des FLASH-Typs (10) aufweist, der durch das Injizieren von heißen Elektronen programmiert wird, aufweisend einen Satz von Programmier-Signalspeichern (PGRC), der vorgesehen ist, um ein sich am Dateneingang (DIN) des FLASH-Speichers (10) befindendes Wort zu speichern, wobei das Verfahren die folgenden Schritte aufweist:
- Vorsehen eines Pufferspeichers (30) mit einer Kapazität, die ausreicht, um die Mehrzahl von Wörtern zu speichern, und Verbinden des Ausgangs des Pufferspeichers mit dem Eingang des FLASH-Speichers,
- Senden der Wortfolge an den Speicher,
- Speichern der an den Speicher gesendeten Wortfolge in dem Pufferspeicher, und anschließendes
- Speichern der Wörter nacheinander in dem FLASH-Speicher mittels der Programmier-Signalspeicher,
wobei das Verfahren **dadurch gekennzeichnet ist, dass** es die Schritte aufweist, die aus Folgendem bestehen:
- Speichern der Wortfolge in dem Pufferspeicher (30), wobei zunächst an den Pufferspeicher eine Adresse angelegt wird, die mindestens N erste Bits (a₁₆-a₂₃) aufweist, die gleich den N Bits mit geringer Signifikanz einer Speicheradresse in dem FLASH-Speicher des ersten Wortes der Wortfolge sind, wobei die an den Pufferspeicher (30) angelegte Adresse nach jedem Speichern eines Wortes inkrementiert wird,
- Speichern der Wörter nacheinander in dem FLASH-Speicher, wobei an den FLASH-Speicher (10) eine Adresse angelegt wird, die M Bits mit hoher Signifikanz (a₀-a₁₅) und N Bits mit geringer Signifikanz (a₁₆-a₂₃) aufweist, wobei die N Bits mit geringer Signifikanz der Adresse eines Wortes auf einer physikalischen Seite des FLASH-Speichers entsprechen, und an den Pufferspeicher (30) eine Adresse angelegt wird, die die N Bits mit geringer Signifikanz (a₁₆-a₂₃) der an den FLASH-Speicher angelegten Adresse aufweist, wobei die an den FLASH-Speicher angelegte Adresse nach jedem Speichern eines Wortes inkrementiert wird.

9. Verfahren gemäß Anspruch 8, wobei die Wörter in Form von Seriendaten (SDATA) empfangen werden und die Seriendaten zu Wörtern (PDATA) rekonstruiert werden, die an den Eingang des Pufferspeichers (30) gesendet werden.

10. Verfahren gemäß einem der Ansprüche 8 oder 9, **dadurch gekennzeichnet, dass** es die Schritte aufweist, die aus Folgendem bestehen:
a) Anlegen an den Adressen-Eingang des Pufferspeichers einer Leseadresse, die mindestens N erste Bits (a₁₆-a₂₃) aufweist, und Lesen eines Wortes in dem Pufferspeicher (30),
b) Anlegen an den Adressen-Eingang des FLASH-Speichers einer Adresse, die M Bits mit hoher Signifikanz (a₀-a₁₅) einer Speicheradresse in dem FLASH-Speicher des ersten Wortes der Wortfolge und N Bits mit geringer Signifikanz aufweist, die mit den N ersten Bits der Leseadresse identisch sind,
c) wenn der Wert des gelesenen Wortes sich von dem Wert eines gelöschten Wortes (FF) unterscheidet, Anlegen an den FLASH-Speicher eines Speichersignals des gelesenen Wortes,
wobei die Schritte a), b), c) wiederholt werden, wobei mit einer Leseadresse begonnen wird, die mindestens N erste Bits aufweist, die gleich "0" sind, bis durch aufeinanderfolgende Inkrementierungen eine Leseadresse erhalten wird, die N erste Bits aufweist, die gleich "1" sind.

11. Verfahren gemäß einem der Ansprüche 8 bis 10, aufweisend einen Überprüfungsschritt, der darin besteht, die nachfolgend genannten Schritte d), e), f) zu wiederholen, wobei mit einer Leseadresse begonnen wird, die N erste Bits aufweist, die gleich "0" sind, bis durch aufeinanderfolgende Inkrementierungen eine Leseadresse erhalten wird, die N erste Bits aufweist, die gleich "1" sind,
d) Anlegen an den Adressen-Eingang des Pufferspeichers der Leseadresse und Lesen eines Wortes in dem Pufferspeicher,
e) Anlegen an den Adressen-Eingang des FLASH-Speichers einer Adresse, die die M Bits mit hoher Signifikanz einer Speicheradresse in dem FLASH-Speicher des ersten Wortes der Wortfolge und N Bits mit geringer Signifikanz aufweist, die mit den N ersten Bits der Leseadresse identisch sind, und Lesen eines Wortes in dem FLASH-Speicher, und
f) Vergleichen des in dem FLASH-Speicher gelesenen Wortes mit dem in dem Pufferspeicher gelesenen Wort.
